# EUROPÄISCHE PATENTANMELDUNG

(11) **EP 3 398 985 A1**
(43) Veröffentlichungstag der Anmeldung: **07.11.2018**
(21) Anmeldenummer: 18169843.2
(22) Anmeldetag: 27.04.2018
(51) Int. Cl.: C08J 7/04, B29C 59/14, C08J 7/12, B05D 3/06, B05D 3/14, B05D 7/04

(54) **VERFAHREN ZUM STRUKTURIEREN EINER SUBSTRATOBERFLÄCHE**

(30) Priorität: 02.05.2017 DE 102017109386
(71) Anmelder: Fraunhofer Gesellschaft zur Förderung der angewandten Forschung e.V., 80686 München (DE)
(72) Erfinder: Steiner, Cindy, 01097 Dresden (DE); Fichtner, Juliane, 01099 Dresden (DE); Günther, Steffen, 01217 Dresden (DE); Kirchhoff, Volker, 01829 Wehlen (DE)

(57) **Zusammenfassung**

Die Erfindung betrifft ein Verfahren zum Herstellen nanoskopischer und/oder mikroskopischer Oberflächenstrukturen auf einem flächig ausgedehnten Substrat, wobei die Oberflächenstruktur des Substrates mittels eines lonenätzprozesses verändert wird. Dabei wird zunächst ein Lack, welcher eine grenzflächenaktive Substanz mit einer Konzentration von 0,01 bis 5 Gewichtsprozent aufweist, auf dem Substrat aufgetragen, anschließend der auf dem Substrat aufgetragene Lack in eine feste Form überführt und danach der lonenätzprozess durchgeführt.

## Beschreibung

Flächig ausgedehnte Materialien, d. h. Materialien, die gegenüber ihrer Dicke eine sehr große Oberfläche aufweisen, wie zum Beispiel Platten oder Bänder aus einem Polymer, aus einem Metall oder aus Glas, weisen oftmals eine sehr glatte Oberfläche auf. Teilweise müssen diese Oberflächen für die Weiterverwendung in technischen Produkten im nanoskopischen und mikroskopischen Maßstab aufgeraut bzw. strukturiert werden. Unter nanoskopischem Maßstab sollen nachfolgend Strukturen verstanden werden, die hinsichtlich ihrer Breite und ihres Abstandes zueinander Abmaße kleiner als 1 µm aufweisen. Dem entsprechend sollen unter mikroskopischem Maßstab nachfolgend Strukturen verstanden werden, die hinsichtlich ihrer Breite und ihres Abstandes zueinander Abmaße kleiner als 1 mm und größer gleich 1 µm aufweisen. Nachfolgend werden diese Dimensionen allgemein als Strukturgröße bezeichnet. Das Aufrauen einer Oberfläche kann beispielsweise sinnvoll sein, um eine optische Entspiegelung zu erzielen.

In Schönberger, W. at al., Large-area fabrication of stochastic nano-structures on polymer webs by ion- and plasma treatment, Surface & Coatings Technology, Vol. 205 (2011), S. 495-S497 (nachfolgend 0 genannt), wird beispielhaft eine Methode vorgestellt, bei der durch einen Plasmaätzprozess ein transparentes Polymer an seiner Oberfläche nanoskopisch aufgeraut wird. Dadurch bildet sich eine poröse Oberfläche aus, die einen graduellen Übergang des optischen Brechungsindex des Polymers zum umgebenden Medium bewirkt. Damit einhergehend wird die optische Reflexion an dieser Grenzfläche über einen weiten Spektralbereich reduziert. Eine erhöhte Lichttransmission ist die Folge. Vorteilhaft ist zusätzlich der zufällige, stochastische Charakter der Strukturierung. Wiederholende Muster bilden sich nicht aus, welche eventuell zu Beugungsphänomenen führen könnten. Nachteilig an dieser Methode ist die Beschränkung auf polymere Materialien, deren Oberflächen aufgeraut werden können.

Auch die in Collaud Coen, M. at al., Modification of the micro- and nanotopography of several polymers by plasma treatments, Applied Surface Science, Vol. 207 (2003) S. 276-286, beschriebene Methode weist ähnliche Nachteile auf. Der beschriebene Prozess ist langsam, kostenaufwendig und auf stationäre Anwendungen beschränkt. Eine dynamische Anwendung, das heißt eine Anwendung auf sich bewegenden Substraten ist damit nicht möglich. Weiterhin ist bei dieser Methode ein großer Nachteil, dass mit einem sogenannten Bias gearbeitet werden muss. Das bedeutet, dass durch eine zusätzliche technische Einrichtung ein elektrisches Potenzial an das aufzurauende Substrat angelegt werden muss, welches die Energie für die zum Aufrauen verwendenden Ionen aus dem Plasma bereitstellt.

In Schulz U. at al., Antireflection of transparent polymers by advanced plasma etching procedures, Optics Express, Vol. 15, No. 20 (2007), S. 13108 - 13113, wird eine zusätzliche Modifikation des Prozesses aus 0 beschrieben. Durch Hinzufügen einer sehr dünnen und nicht geschlossenen Materialschicht im Dickenbereich weniger Nanometer wird die Ausbildung der Strukturen hinsichtlich Größe und Form beeinflusst. Jedoch wird auch mit diesem Prozess die Einschränkung auf polymere Materialien nicht überwunden.

Um beliebige Materialarten mit einer strukturierten Oberfläche auszustatten, gibt es die Möglichkeit, auf diese Materialien eine Lackschicht aufzubringen, deren Oberfläche noch im nassen Zustand zu strukturieren und diese Struktur dann im Vernetzungsschritt des Lackes "einzufrieren". Eine solche Methode wird zum Beispiel in Bauer F. at al., UV curing and matting of acrylate nanocomposite coatings by 172nm excimer irradiation in Progress, Organic Coatings, Vol. 64, No. 4, (2009), S. 474-481, beschrieben. Dabei wird durch einen ersten Bestrahlungsschritt ein auf UV-Strahlung empfindlicher Lack lediglich an der Oberfläche im mikroskopischen Maßstab stochastisch gefaltet. In einem zweiten Schritt wird unter Verwendung eines zweiten UV-Strahlers die gesamte Lackdicke vom nassen in den festen Zustand überführt. Man spricht hierbei von der Vernetzung des Lackes. Bei diesem Verfahren werden Strukturgrößen im mikroskopischen Bereich generiert. Nanoskopische Strukturgrößen können mit diesem Verfahren jedoch nicht hergestellt werden. Deshalb kann mit einem solchen Verfahren keine breitbandige Entspiegelungswirkung erreicht werden.

Eine weitere sehr aufwändige Methode zum Strukturieren von Oberflächen ist in Kooy, N. at al., A review of roll-to-roll nanoimprint lithography, Nanoscale Res Lett., Vol. 9, No. 1 (2014), S. 320 ff., offenbart. Dabei wird ein auf UV-Strahlung empfindlicher Lack in seinem nassen Zustand durch einen Stempel geometrisch verformt und unmittelbar im Anschluss ohne Wegnahme des Stempels vernetzt. Nach dem Vernetzen des Lackes wird der Stempel wieder entfernt und es verbleibt der geformte Lack als Oberfläche. Der für diese Art des Strukturierens einer Oberfläche benötigte Stempel kann nur sehr aufwändig hergestellt werden. Stochastische Strukturen sind damit nicht herstellbar und die Strukturen weisen über eine gewisse Dimension Wiederholungen auf, da der Stempel für die Strukturierung größerer Flächen wiederholt aufgesetzt werden muss. An den Ansatzstellen entstehen darüber hinaus immer Strukturstörungen, da der Stempel nicht exakt und ansatzlos positioniert werden kann. Für Änderungen der Strukturgrößen muss jedes Mal ein neuer Stempel gefertigt werden. Das macht den Prozess zusätzlich zeit- und kostenaufwendig.

Der Erfindung liegt daher das technische Problem zugrunde, ein Verfahren zum Strukturieren von Oberflächen zu schaffen, mittels dessen die Nachteile aus dem Stand der Technik überwunden werden können. Insbesondere soll es mit dem erfindungsgemäßen Verfahren möglich sein, die Oberflächen von Substraten verschiedener Materialien, wie zum Beispiel aus metallenen oder gläsernen Materialien zu strukturieren.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren zum Herstellen nanoskopischer und/oder mikroskopischer Oberflächenstrukturen auf einem flächig ausgedehnten Substrat wird zunächst ein Lack auf die Substratoberfläche aufgetragen und auf der Substratoberfläche in eine feste Form überführt. In einem zweiten Schritt wird diese feste Lackoberfläche dann einem Plasmaätzprozess ausgesetzt, durch den die Oberfläche aufgeraut bzw. strukturiert wird. Der maßgebliche Erfindungsgedanke besteht darin, dem Nasslack vor dem Auftragen auf das Substrat einen als grenzflächenaktive Substanz ausgebildeten chemischen Zusatzstoff beizumischen. Dabei bestimmt die Konzentration und die Art der grenzflächenaktiven Substanz maßgeblich, wie sich beim späteren Plasmaätzprozess die Struktur hinsichtlich Porosität, Strukturgröße, effektiver Oberfläche usw. ausbilden wird. Unter grenzflächenaktive Substanz sollen Stoffe verstanden werden, welche sich an Phasengrenzen anreichern und die Oberflächenspannung bzw. die Grenzflächenspannung zwischen zwei Phasen herabsetzen.

Der zu verwendende Lack ist flüssiger Natur. Durch chemische oder physikalische Vorgänge wird er zu einem durchgehenden, großflächigen, festen Film umgebaut. Wichtiger Bestandteil des flüssigen Lackes ist ein Filmbildner, der Hauptbestandteil der sich später ausbildenden festen Schicht ist. Zum Einstellen der Viskosität des flüssigen Lackes können Lösemittel oder Reaktivverdünner dem flüssigen Filmbildner zugegeben werden. Die Verarbeitbarkeit des Lackes wird dadurch in starkem Maße bestimmt und kann über die Art und Konzentration der Lösemittel bzw. Reaktivverdünner durch verschiedene Methoden der Nasslackapplikation angepasst werden. Weitere Bestandteile des Lackes können Pigmente oder andere feste Füllstoffe sein. Vorteilhaft sind hierbei Lacke, die lösemittelfrei sind. Die Belastung der Umwelt wird dadurch drastisch verringert. Besonders vorteilhaft stellen sich strahlungsvernetzende Lacke dar, die acrylatbasiert sind. Dadurch können hocheffiziente und hochproduktive Methoden der Strahlungsvernetzung eingesetzt werden. Darüber hinaus weisen insbesondere urethanacrylatbasierte Lacke eine ausreichende Stabilität gegenüber Witterungseinflüssen auf und können damit auch für Anwendungen im Außenbereich eingesetzt werden.

Neben flüssigen Lacken ist auch das Verwenden eines Pulverlackes denkbar. Dabei erfolgt die Zugabe des chemischen Zusatzstoffes bei der Synthese der Pulverpartikel.

Als chemischer Zusatzstoff zum Einstellen der sich im anschließenden Plasmaätzprozess ausbildenden Strukturen soll eine grenzflächenaktive Substanz gewählt werden, weil dadurch gewährleistet ist, dass diese Substanz vorrangig an der Oberfläche der Lackschicht ihre Wirkung entfaltet. Die Konzentration des Zusatzstoffes soll dabei zwischen 0,01 Gewichtsprozent bis 5 Gewichtsprozent liegen. Die Änderung der Volumeneigenschaften der Lackschicht wird dadurch gering gehalten. Besonders vorteilhaft hat sich ein Konzentrationsbereich von 0,05 Gewichtsprozent bis 3 Gewichtsprozent für die grenzflächenaktive Substanz erwiesen. Dadurch ergibt sich eine große Spannbreite an einstellbaren Strukturgrößen beim anschließenden Plasmaätzprozess und gleichzeitig ein nahezu unverändertes Eigenschaftsprofil der Lackschicht, unabhängig vom Vorhandensein der grenzflächenaktiven Substanz.

Vorteilhaft ist das Verwenden einer siloxanbasierten Substanz als grenzflächenaktive Substanz, da sich dadurch beim späteren lonenätzprozess die Strukturgrößen über einen großen Parameterbereich einstellen lassen. Besonders im Zusammenhang mit der Verwendung eines strahlungshärtenden Lackes ist das Verwenden einer siloxanbasierten Substanz mit Acrylat-Funktionalität wichtig. Dadurch wird sichergestellt, dass die Substanz chemisch an die Lackschicht haftfest angebunden wird und sich von dieser durch einfache mechanische Belastungen, wie zum Beispiel durch Abwischen, nicht trennen lässt. Als besonders vorteilhaft hat sich das Verwenden eines polyestermodifizierten, multiacrylfunktionellen Polydimethylsiloxan als grenzflächenaktive Substanz erwiesen. Die Bandbreite an erzielbaren Strukturgrößen in Abhängigkeit von der Konzentration dieses Stoffes hat sich als sehr hoch erwiesen und gewährleistet so die Anpassung der Strukturen an verschiedenste Anwendungsaufgaben.

Als Methode zum Überführen des Lackes in eine geschlossene, feste Form können gebräuchliche Trocknungsmethoden (Infrarottrocknung, thermische Trocknung, Mikrowelle oder Einbrennen) oder Methoden der Strahlungsvernetzung (Elektronenbestrahlung, UV-Bestrahlung, LED-UV-Bestrahlung, Blitzlampenbestrahlung, Laserbestrahlung) oder Kombinationen daraus angewandt werden. Vorteilhaft sind insbesondere die Methoden der Strahlungsvernetzung, da hierbei auf den Einsatz von Lösemitteln im Lack verzichtet werden kann. Als besonders vorteilhaft ist die Elektronenbestrahlung zu nennen, da eine thermische Beeinflussung des Materials dadurch weiter minimiert wird und eine sehr hohe Produktivität erreicht werden kann.

Für den Auftrag des Lackes auf die Materialoberfläche eignen sich jegliche, gebräuchliche Methoden zur großflächigen Applikation. Beispielhaft können dies eine Walzenbeschichtung, eine Rakelbeschichtung, eine Sprühbeschichtung oder eine Beschichtung mittels Schlitzdüse sein. Besonders vorteilhaft stellt sich die Schlitzdüsenbeschichtung dar, da sie auf großer Breite sehr gleichmäßig und ohne Berührung der Materialoberfläche den Lack applizieren kann.

Die Erfindung wird nachfolgend an einem Ausführungsbeispiel beschrieben. Hierbei wurden drei verschiedene Abschnitte einer PET-Folie (Typ: Melinex® 401, 50 µm dick) jeweils mit einer 20 µm dicken Lackschicht beschichtet. Die Beschichtung erfolgte mittels eines Spiralrakels. Im Anschluss wurde die Lackschicht auf den drei Folienabschnitten durch Elektronenbestrahlung vernetzt, wobei eine Bestrahlungsdosis von 45 kGy unter inerten Bedingungen (< 200 ppm Sauerstoff) zum Einsatz kam. Die drei Abschnitte der Folie wurden mit drei verschiedene Lackformulierungen beschichtet. Für den ersten Abschnitt wurde ein Lack A aus 52,8 % aliphatischem Urethanacrylat und 47,2 % 1,6 Hexandioldiacrylat hergestellt. Für das Beschichten des zweiten Folienabschnitts wurde ein Lack B hergestellt, welcher aus Lack A besteht, der zusätzlich mit 0,1 Gewichtsprozent polyestermodifizierten, acrylfunktionellen Polydimethylsiloxan versetzt wurde. Für das Beschichten des dritten Folienabschnitts wurde ein Lack C hergestellt, welcher aus Lack A besteht, der zusätzlich mit 3 Gewichtsprozent polyestermodifizierten, acrylfunktionellen Polydimethylsiloxan versetzt wurde.

Nach dem Lackieren und Vernetzen der drei Folienabschnitte mit den verschiedenen Lacken A, B und C, wurden die Lackschichten anschließend ionengeätzt. Das Ätzen erfolgte mittels Ionen aus einem Sauerstoffplasma über einem Doppelmagnetron unter Verwendung von Aluminiumtargets bei einem Sauerstoffgasfluss von 200 sccm, einem Prozessdruck von 0,3 Pa und einer Leistungsdichte am Target von 3,6 W/cm². Die Prozessdaten des Doppelmagnetrons wurden dabei derart eingestellt, dass möglichst kein Sputterabtrag an den Aluminiumtargets entsteht. Ein plasmaerzeugendes Magnetron fungiert beim erfindungsgemäßen Verfahren vornehmlich zum Erzeugen eines Plasmas und nicht zum Erzeugen schichtbildender Partikel herrührend aus den Magnetrontargets.
Im Anschluss wurden die hergestellten Proben hinsichtlich verschiedener Eigenschaften charakterisiert. Die optische Transmission der drei Folienabschnitte (nachfolgend auch Proben genannt) vor und nach dem Plasmaätzschritt wurde spektral über einen Wellenlängenbereich von 250 nm bis 2500 nm gemessen. Aus dem Spektrum wurde die visuelle Transmission über die Wichtung mit der Hellempfindlichkeit des menschlichen Auges berechnet. Im Anschluss wurde die Transmissionsänderung der Proben, die durch den Plasmaätzschritt hervorgerufen wurde, berechnet. Es zeigte sich zwischen den Proben des Lackes A und Lackes B kein Unterschied. Beide zeigten gleichermaßen eine Transmissionssteigerung um 0,8 % absolut. Die Probe des Lackes C hingegen zeigte einen Transmissionsgewinn von 1,1 % absolut. Nicht nur die Transmissionssteigerung sondern auch die Absoluttransmission war für Lack C am höchsten.

An den geätzten Proben wurde die effektive Oberfläche bestimmt. Dabei wird ermittelt, wie stark strukturiert bzw. aufgeraut die Oberfläche im Vergleich zu einer perfekt planen Oberfläche ist. Für Lack B wurde im Vergleich mit Lack A keine Änderung der effektiven Oberfläche ermittelt. Es zeigte sich jedoch für Lack C eine gegenüber Lack A verringerte effektive Oberfläche. Im Zusammenhang mit der Beobachtung zur optischen Transmission ist dies erstaunlich, da man bei einer weniger stark strukturierten Oberfläche eher eine Transmissionsverringerung statt einer Transmissionserhöhung erwarten würde. Vorteilhaft ist die hohe optische Transmission bei gleichzeitig verringerter effektiver Oberfläche zum Beispiel für optische Geräte, die in einem haptischen Einwirkbereich liegen. Verschmutzungen durch Fingerfett sollten durch die weniger stark strukturierte Oberfläche des Lackes C weniger leicht "verschmiert" werden.

Die Beständigkeit gegenüber mechanischen Belastungen (Abrieb) wurde durch einen Taber Abraser Test in Anlehnung an DIN 52 347 bestimmt. Dabei reiben zwei Reibrollen (CS10F) 100 Mal auf den jeweiligen Probenoberflächen mit einer Belastung von 250 g. Nach definierten Zeitabständen wurde an den Proben der Glanzverlust als Maß für die Veränderung der Oberfläche durch den mechanischen Einfluss gegenüber der Ausgangssituation durch Reflexionsmessung unter einem Winkel von 60° gemessen. Weiterhin wurden Lichtmikroskopbilder angefertigt, um die Oberflächen hinsichtlich Kratzern und anderen Einflussbildern zu untersuchen. Der Glanzverlust war bei der Probe des Lackes A am größten. Der geringste Glanzverlust wurde bei der Probe des Lackes B ermittelt. Die Lichtmikroskopbilder zeigten für die Lackprobe C die geringsten Kratzerdichten und Kratzertiefen. Die bloße Anwesenheit des als grenzflächenaktive Substanz ausgebildeten chemischen Zusatzstoffes erhöhte also die Abriebbeständigkeit für Lack B und Lack C, jedoch ist eine Optimierung hinsichtlich dessen Konzentration je nach hauptsächlich vorliegender Belastungsart möglich.

Die Benetzung der plasmageätzten Lackoberfläche durch Wasser wurde mittels einer Kontaktwinkelmessung untersucht. Dabei zeigte sich bei Lack A und Lack B ein vergleichbarer Kontaktwinkel, während Lack C einen geringeren Kontaktwinkel aufwies. Insbesondere für Anwendungen im Außenbereich ist ein hoher Kontaktwinkel positiv, da dadurch die Selbstreinigung der Oberflächen verbessert wird. Lack B vereint nun die Eigenschaft eines hohen Kontaktwinkels mit dem geringsten Glanzverlust. Durch den plasmageätzten Lack B lassen sich zum Beispiel optische Geräte (Solarmodule) im Außenbereich effektiv gegenüber Verschmutzung und mechanischer Beeinflussung schützen.

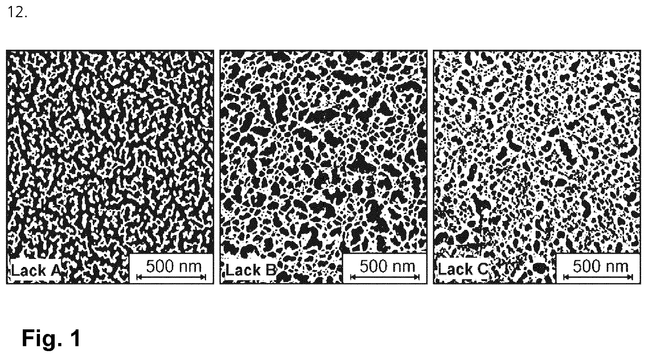

Anhand rasterelektronenmikroskopischer Aufnahmen der plasmageätzten Lackoberflächen (dargestellt in Fig. 1) sind große Unterschiede der Strukturen der Lacke A, B und C zu erkennen. Die Bereiche, die in das Material hineinweisen werden im Weiteren als Poren bezeichnet. Lack A zeigt Strukturen, die einzeln stehend aus der Oberfläche herausragen. Die Poren sind bei Lack A nicht einzeln, sondern größtenteils miteinander verbunden. Es bildet sich also ein Netzwerk aus Poren. Lack B und Lack C zeigen dagegen Strukturen, die netzartig verbunden sind und die Poren sind vereinzelt. Bezogen auf verschiedene Anwendungsfälle lassen sich also durch Variation des chemischen Zusatzstoffes die Strukturtypen über einen weiten Charakteristikbereich anpassen.

Anhand der Fläche der Poren im Verhältnis zur gesamten, projizierten Oberfläche kann der Porenflächenanteil berechnet werden. Lack A weist den größten Porenflächenanteil auf. Lack B hat einen mittleren Porenflächenanteil und Lack C den geringsten der drei Proben. Auch der Porenflächenanteil lässt sich durch den chemischen Zusatzstoff variieren.
Die verschiedenen erfassten Messgrößen zeigen unterschiedliche Abhängigkeiten von dem chemischen Zusatzstoff. Es ergibt sich daraus ein hohes Potenzial an Optimierungsmöglichkeiten, um die verschiedenen Parameter auf unterschiedliche Anwendungen anpassen zu können.

## Patentansprüche

1. Verfahren zum Herstellen nanoskopischer und/oder mikroskopischer Oberflächenstrukturen auf einem flächig ausgedehnten Substrat, wobei die Oberflächenstruktur des Substrates mittels eines lonenätzprozesses verändert wird, **dadurch gekennzeichnet, dass**
a) zunächst ein Lack, welcher eine grenzflächenaktive Substanz mit einer Konzentration von 0,01 bis 5 Gewichtsprozent aufweist, auf dem Substrat aufgetragen,
b) der auf dem Substrat aufgetragene Lack in eine feste Form überführt und
c) danach der Ionenätzprozess durchgeführt wird.

2. Verfahren nach Anspruch 1, **dadurch gekennzeichnet, dass** ein Lack verwendet wird, der eine grenzflächenaktive Substanz mit einer Konzentration von 0,1 bis 3 Gewichtsprozent aufweist.

3. Verfahren nach Anspruch 1 oder 2, **dadurch gekennzeichnet, dass** ein Lack verwendet wird, der mittels Strahlungsvernetzen in eine feste Form überführt werden kann.

4. Verfahren nach Anspruch 4, **dadurch gekennzeichnet, dass** zum Vernetzen des Lackes eine Elektronenbestrahlung angewendet wird.

5. Verfahren nach einem der vorhergehenden Ansprüche, **dadurch gekennzeichnet, dass** ein acrylatbasierter Lack verwendet wird.

6. Verfahren nach Anspruch 5, **dadurch gekennzeichnet, dass** ein urethanacrylatbasierter Lack verwendet wird.

7. Verfahren nach einem der vorhergehenden Ansprüche, **dadurch gekennzeichnet, dass** ein siloxanbasierter Zusatzstoff als grenzflächenaktive Substanz verwendet wird.

8. Verfahren nach Anspruch 7, **dadurch gekennzeichnet, dass** ein polyestermodifiziertes, multiacrylfunktionelles Polydimethylsiloxan als grenzflächenaktive Substanz verwendet wird.

9. Verfahren nach einem der vorhergehenden Ansprüche, **dadurch gekennzeichnet, dass** ein Plasmaätzprozess als lonenätzprozess verwendet wird.

10. Verfahren nach Anspruch 9, **dadurch gekennzeichnet, dass** für den Plasmaätzprozess ein mittels eines Magnetrons erzeugtes Sauerstoffplasma verwendet wird.

11. Verfahren nach einem der vorhergehenden Ansprüche, **dadurch gekennzeichnet, dass** der Lack mittels Schlitzdüsenauftrag auf das Substrat aufgetragen wird.
